Europäisches Patentamt

European Patent Office

Office européen des brevets

(19)

(11) Numéro de publication : **0 407 298 B1**

(12) **FASCICULE DE BREVET EUROPEEN**

(45) Date de publication du fascicule du brevet :
**06.04.94 Bulletin 94/14**

(51) Int. Cl.⁵ : **H01L 33/00, H01S 3/025, C23C 14/54**

(21) Numéro de dépôt : **90401936.1**

(22) Date de dépôt : **04.07.90**

(54) **Procédé de contrôle de l'épaisseur d'une couche antireflet et installation de mise en oeuvre.**

(30) Priorité : **06.07.89 FR 8909119**

(43) Date de publication de la demande :
**09.01.91 Bulletin 91/02**

(45) Mention de la délivrance du brevet :
**06.04.94 Bulletin 94/14**

(84) Etats contractants désignés :
**DE GB**

(56) Documents cités :
**GB-A- 2 029 017
US-A- 3 846 165
APPLIED OPTICS, vol. 27, no. 8, avril 1988,
pages 1391-1393, New York, US; A. SOMANI et
al.: "Real-time monitoring of laser diode facet
reflectivity while being coated with SiOx"
APPLIED OPTICS, vol. 26, no. 5, 1 mars 1987,
pages 854-849, New York, US; M. SERENYI et
al.: "Directly controlled deposition of antireflection coatings for semiconductor lasers"**

(73) Titulaire : **FRANCE TELECOM
Etablissement autonome de droit public, 6,
Place d'Alleray
F-75015 Paris (FR)**

(72) Inventeur : **Landreau, Jean
11, rue Marcel Maillard
F-92160 Antony (FR)**
Inventeur : **Nakajima, Hisao
97, rue de la Tombe-Issoire
F-75014 Paris (FR)**

(74) Mandataire : **Gandrille, Pierre et al
Société de Protection des Inventions 25, rue
de Ponthieu
F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**Description**

## PROCEDE DE CONTROLE DE L'EPAISSEUR D'UNE COUCHE ANTI-REFLET ET INSTALLATION DE MISE EN OEUVRE.

La présente invention a pour objet un procédé de contrôle de l'épaisseur d'une couche antireflet et une installation de mise en oeuvre. Elle trouve une application dans le traitement antireflet des faces des lasers à semi-conducteur.

On sait qu'une couche antireflet est une couche dont l'indice n satisfait à la relation $n^2 = n_0$ où $n_0$ est l'indice du substrat sur lequel elle est déposée et dont l'épaisseur est égale à $\lambda/4n$ où $\lambda$ est la longueur d'onde.

Pour un matériau donné, l'épaisseur peut être ajustée pour obtenir une bonne couche antireflet. Il est admis qu'une "bonne" couche antireflet est une couche dont la réflectivité est inférieure à $10^{-3}$. Cette valeur très faible impose des contraintes sévères sur l'épaisseur qui doit être ajustée à mieux que $10^{-2}$.

L'obtention de bonnes couches antireflet est donc relativement difficile.

On connaît un procédé de contrôle de l'épaisseur d'une telle couche lorsqu'elle est déposée sur un laser à semi-conducteur. Pendant l'opération de dépôt sur l'une des faces émettrices d'un laser à semiconducteur, on alimente ce laser en courant, à une valeur constante située au-dessus du seuil d'oscillation du laser. La lumière émise par celui-ci à travers la face arrière (opposée à celle qui est en cours de traitement) est mesurée par un photorécepteur. Son intensité dépend de la réflectivité de la face avant : moins cette face est réfléchissante, plus il y a de pertes dans le résonateur et moins la lumière émise par l'autre face est intense. Ainsi, la puissance mesurée diminue-t-elle avec la réflectivité de la couche antireflet. En détectant le passage de cette puissance par un minimum, on détermine l'instant où la couche antireflet offre le minimum de réflectivité.

Ce procédé est décrit notamment dans l'article de M. SERENYI et al intitulé "Directly controlled deposition of antireflection coatings for semiconductor laser" publié dans la revue "Applied Optics", March 1, 1987, vol. 26, N° 5, pp 845-849.

Cet article décrit une autre technique consistant à exciter le laser en dessous du seuil (et non plus au-dessus) et à mesurer l'intensité de la lumière spontanée émise à travers la face en cours de traitement (et non plus à travers la face opposée). Dans ce cas, on recherche un maximum de puissance lumineuse, lequel est obtenu lorsque la réflectivité de la couche est à son minimum. Cette méthode (dite A) est un peu moins précise que la précédente (dite B), car le spectre d'émission spontanée est plus large que celui de l'émission stimulée obtenue au-dessus du seuil.

Ces techniques (aussi bien A que B) présentent de nombreux inconvénients : tout d'abord, le photorécepteur utilisé doit être placé de manière à recueillir un maximum de lumière ; or, cette exigence est incompatible avec la nécessité de ne pas masquer la face à traiter. Ensuite, ce même photorécepteur étant sensible à la lumière émise dans l'enceinte de dépôt (canon d'évaporation ou plasma), pour masquer cette lumière parasite il faut utiliser des filtres interférométriques, qui réduisent l'intensité lumineuse à mesurer ; cet affaiblissement est d'autant plus gênant qu'à son minimum l'intensité à mesurer est déjà très faible. Enfin, un alignement rigoureux doit être réalisé entre le laser et le photorécepteur, à l'aide de lentilles, miroirs, fibres optiques, ce qui complique sensiblement l'installation.

Le but de la présente invention est justement de remédier à tous ces inconvénients. A cette fin, l'invention propose de renoncer à ces techniques connues qui sont toutes de caractère optique pour adopter un procédé de caractère électrique. Selon l'invention, on mesure la tension aux bornes du laser à semi-conducteur alimenté en courant constant au-dessus du seuil et on détecte le passage par un maximum de cette tension. Ce maximum correspond au minimum de réflectivité de la couche antireflet.

Cette surprenante corrélation entre une grandeur optique (la réflectivité d'une couche) et une grandeur électrique (la tension aux bornes du laser) peut s'expliquer de la manière suivante, selon les inventeurs.

Dans un laser à semi-conducteur, pour un courant d'injection donné, le nombre de porteurs dans la zone active est inversement proportionnel au nombre de photons présents dans la cavité. La densité de porteurs (c'est-à-dire le nombre de porteurs par unité de volume) détermine l'écartement des quasi-niveaux de Fermi et, par conséquent, la tension aux bornes du laser.

Par ailleurs, l'intensité lumineuse à l'intérieur de la cavité laser résulte d'un équilibre entre l'amplification par émission stimulée et les pertes optiques de la cavité. Pour un courant d'injection constant, une augmentation des pertes liées à la diminution de la réflectivité d'une des faces entraîne une diminution de l'intensité lumineuse à l'intérieur de la cavité. Cette diminution réduit l'émission stimulée, ce qui a pour effet d'augmenter la densité de porteurs et donc de faire croître la tension aux bornes du laser.

Rechercher la meilleure couche antireflet revient donc bien à détecter un maximum de tension aux bornes du laser.

La présente invention a également pour objet une installation de dépôt de couche antireflet qui met en oeuvre le procédé qui vient d'être défini.

De toute façon, les caractéristiques de l'invention apparaîtront mieux à la lumière de la description qui suit, d'exemples de réalisation donnés à titre explicatif et nullement limitatif. Cette description se réfère à des dessins annexés sur lesquels :

- la figure 1 illustre un montage expérimental permettant de suivre l'évolution de la tension en cours de traitement,
- la figure 2 montre une courbe relevée avec un tel montage,
- la figure 3 montre trois courbes résultant de calculs et correspondant à un indice égal à 1,85,
- la figure 4 montre trois autres courbes correspondant à un indice de 1,80,
- la figure 5 illustre schématiquement une installation conforme à l'invention avec arrêt automatique du traitement.

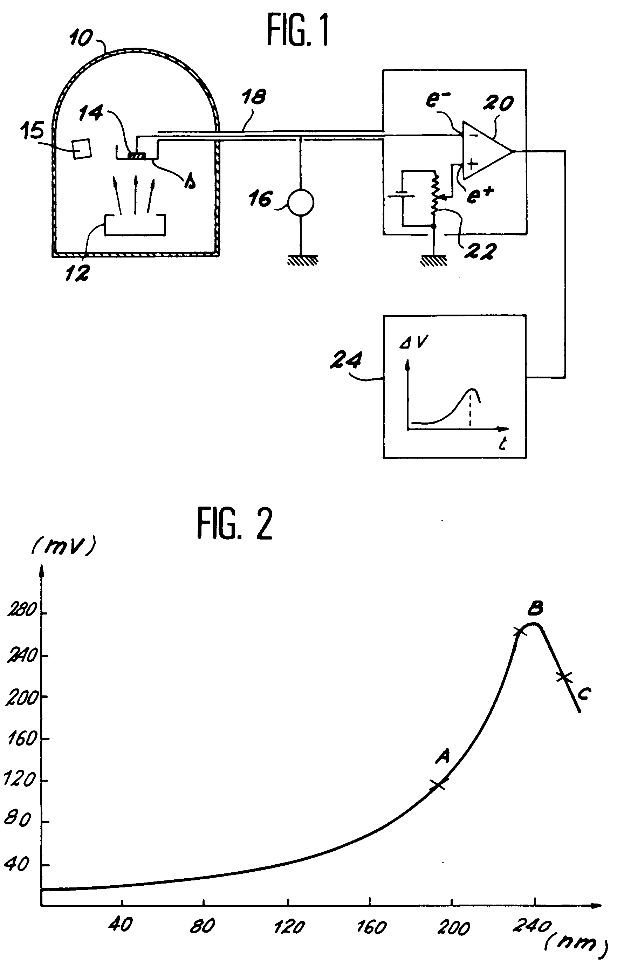

On a représenté sur la figure 1, un montage expérimental par lequel le Demandeur a vérifié le bien-fondé du procédé inventé. Ce montage comprend une enceinte 10 munie d'un moyen d'évaporation 12 ; à l'intérieur de cette enceinte est disposé un support laser s et, sur ce support, un laser semi-conducteur 14 (une des faces émettrices orientée vers le moyen d'évaporation). L'enceinte comprend encore un appareil 15 destiné à mesurer l'épaisseur de la couche déposée. Le montage comprend encore une source de courant constant 16 reliée par une connexion 18 à la structure à traiter 14. Un amplificateur opérationnel 20 possède une entrée inverseuse $e^-$ reliée à la source de courant 16 et une entrée directe $e^+$ reliée à un potentiomètre 22. Ce potentiomètre est réglé initialement pour équilibrer la tension appliquée sur l'entrée inverseuse. Un enregistreur 24 relié à la sortie de l'amplificateur différentiel permet de relever la tension délivrée par celui-ci, laquelle n'est autre que la variation de tension aux bornes du laser à semi-conducteur 14.

La figure 2 montre la courbe obtenue dans le cas d'un dépôt de SiO comme matériau antireflet. En abscisse est portée l'épaisseur ep de la couche mesurée par l'appareil du dépôt 15 et exprimée en nanomètres et, en ordonnées, la tension délivrée par l'amplificateur opérationnel exprimée en millivolts. La valeur de la réflectivité a été mesurée à trois reprises en interrompant le dépôt.

Les trois points A, B, C marqués sur la courbe correspondent aux valeurs suivantes :

| | épaisseur (nm) | réflectivité ($10^{-3}$) | tension laser (mV) |
|---|---|---|---|
| A | 190 | 35 | 10 |
| B | 233 | 0,1 | 23 |
| C | 253 | 5 | 15,2 |

Cette courbe et ces valeurs montrent bien la corrélation entre le minimum de réflectivité et le maximum de tension aux bornes du laser.

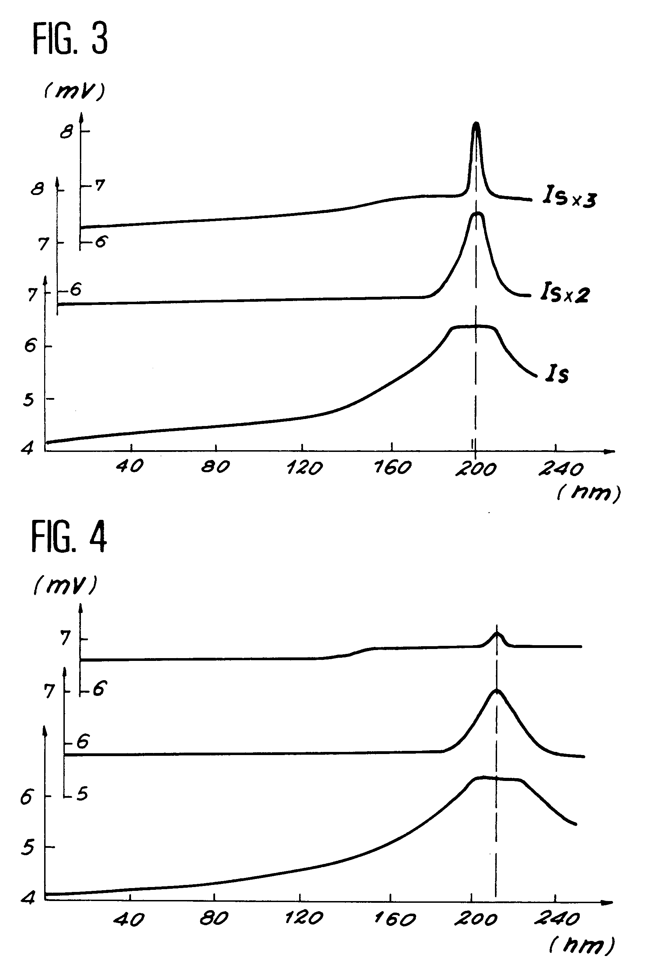

Les courbes des figures 3 et 4, obtenues par le calcul, permettent de mieux apprécier l'influence de la valeur du courant du laser.

Pour toutes ces courbes, l'épaisseur de la couche est exprimée en nanomètres et est portée en abscisses, la variation de tension aux bornes du laser étant portée en ordonnées.

Les trois courbes correspondent à trois valeurs du courant : la première égale au courant de seuil Is, la deuxième égale à deux fois le seuil et la troisième égale à trois fois ce seuil.

La figure 3 correspond au cas où le matériau déposé possède un indice égal à 1,85. La réflectivité minimale est égale à $10^{-5}$ pour une épaisseur d'environ 200 nm.

La figure 4 correspond au cas d'un indice égal à 1,80. La réflectivité minimale est de $5 \times 10^{-4}$ pour une épaisseur d'environ 210 nm.

On observera l'existence d'une saturation de la tension lorsque le courant injecté est égal au seuil, et cela pour une réflectivité de $3.10^{-3}$. Pour un courant injecté égal à deux fois le courant de seuil, la saturation est beaucoup moins marquée et correspond à une réflectivité inférieure à $10^{-4}$. On préférera donc en général injecter un courant égal à trois fois le courant de seuil. On pourra alors apprécier un minimum de réflectivité aussi faible que $5 \times 10^{-6}$.

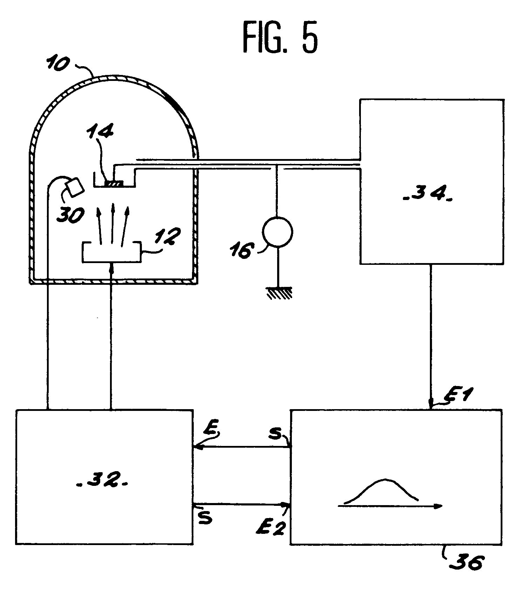

L'installation illustrée sur la figure 5 comprend des moyens déjà représentés sur la figure 1, à savoir une enceinte 10, un moyen d'évaporation 12, un laser à semi-conducteur 14, et une source de courant 16. L'installation représentée comprend en outre une balance à quartz 30 capable de mesurer l'épaisseur de la couche déposée, un appareil 32 de commande du moyen d'évaporation avec une entrée E et une sortie S délivrant un signal fonction de l'épaisseur $\underline{e}$ mesurée par la balance à quartz 30. Un voltmètre numérique 34 est relié à la source de courant. Un calculateur 36 possède une première entrée E1 reliée au voltmètre 34, une seconde entrée E2 reliée à la sortie S de l'appareil de commande 32 et une sortie S reliée à l'entrée E de ce même appareil.

Le calculateur 36 reçoit la tension V du voltmètre 34 et la valeur de l'épaisseur $\underline{e}$ délivrée par l'appareil 32 ; il calcule la dérivée dV/de et détermine l'instant où celle-ci s'annule. Dès lors, il adresse à l'appareil 32 un signal d'arrêt de l'évaporation, signal qui est appliqué sur l'entrée E.

Un tel système peut travailler avec plusieurs lasers, traités les uns après les autres grâce à un système de cache. La productivité du processus de fabrication s'en trouve améliorée.

Pour ce qui est des matériaux à utiliser, tous les matériaux connus et à venir conviennent. L'article cité plus haut décrit certaines conditions opératoires qui peuvent très bien être utilisées dans le cadre de la présente invention.

## Revendications

1. Procédé de contrôle de l'épaisseur d'une couche antireflet en cours de dépôt sur l'une des faces d'un laser à semi-conducteur (14), dans lequel on alimente le laser en courant constant (16) en cours de dépôt, ce procédé étant caractérisé par le fait qu'on mesure la tension (V) aux bornes du laser, on détecte le passage de cette tension par un maximum, ce qui indique que la couche antireflet présente une épaisseur lui donnant une réflectivité minimale.

2. Installation de dépôt de couche antireflet sur l'une des faces d'un laser semi-conducteur, pour la mise en oeuvre du procédé selon la revendication 1, cette installation comprenant une enceinte de dépôt (10) équipée d'un moyen d'évaporation (12) et d'un support de laser (s), un moyen de commande du moyen d'évaporation (12) et une source de courant constant (16) reliée à une connexion (18) débouchant à l'intérieur de l'enceinte, cette installation étant caractérisée par le fait qu'elle comprend en outre un moyen apte à détecter l'instant où la tension aux bornes de la source de courant passe par un maximum.

3. Installation selon la revendication 2, caractérisée par le fait qu'elle comprend en outre un moyen (36) apte à délivrer un signal d'arrêt au moyen (32) de commande du moyen d'évaporation (12) lorsque la tension passe par un maximum.

4. Installation selon la revendication 2, caractérisée par le fait qu'elle comprend un amplificateur différentiel (20) ayant une entrée inverseuse ($e^-$) reliée à la source de courant constant et une entrée directe ($e^+$) reliée à un potentiomètre (22).

5. Installation selon la revendication 2, caractérisée par le fait qu'il comprend un voltmètre numérique (34).

6. Installation selon la revendication 5, caractérisée par le fait qu'elle comprend en outre un moyen (30) pour mesurer l'épaisseur de la couche déposée, ce moyen étant disposé dans l'enceinte (10) et étant relié au moyen de commande (32) du moyen d'évaporation.

7. Installation selon la revendication 6, caractérisée par le fait qu'elle comprend un calculateur (36) ayant deux entrées, l'une (E1) reliée au voltmètre (34) d'où elle reçoit la valeur de la tension (V), l'autre (E2) reliée au moyen (32) de commande du moyen d'évaporation d'où elle reçoit un signal ($\underline{e}$) de mesure de l'épaisseur de la couche déposée, ce calculateur (36) calculant la dérivée (dV/de) de la tension (V) par rapport à l'épaisseur (e), ce calculateur (36) ayant une sortie (S) reliée au moyen (32) de contrôle du moyen d'évaporation, le calculateur délivrant sur cette sortie un signal d'arrêt lorsque ladite dérivée est nulle.

## Patentansprüche

1. Verfahren zur Kontrolle der Dicke eines Entspiegelungsbelags während der Beschichtung einer der Flächen eines Halbleiterlasers (14), wobei der Laser durch Gleichstrom (16) gespeist wird, dadurch gekennzeichnet, daß die Spannung (V) an den Klemmen des Lasers gemessen wird, der Durchgang dieser Spannung an einem Maximum erkennbar ist, das darauf hinweist, daß der Entspiegelungsbelag eine Dicke aufweist, die ihr minimales Reflexionsvermögen verleiht.

2. Anlage zum Auftragen eines Entspiegelungsbelags auf einer der Flächen eines Halbleiterlasers zur Durchführung des Verfahrens nach Anspruch 1, wobei diese Vorrichtung eine Beschichtungskammer (10) mit einem Verdampfungsmittel (12) und einem Lasermedium, eine Steuerung für das Verdampfungsmittel (12) sowie eine Gleichstromquelle (16) verbunden mit einer Schaltung (16), die ins Innere der Beschichtungskammer führt, umfaßt, dadurch gekennzeichnet, daß die Anlage außerdem ein Mittel umfaßt, das den Zeitpunkt erkennt, an dem an den Klemmen der Stromquelle eine maximale Spannung herrscht.

3. Anlage gemäß Anspruch 2, dadurch gekennzeichnet, daß sie außerdem ein Mittel (36) umfaßt, das der Steuerung (32) des Verdampfungsmittels (12) ein Haltesignal liefert, wenn die Spannung ein Maximum erreicht.

4. Anlage gemäß Anspruch 2, dadurch gekennzeichnet, daß sie einen Differentialverstärker (20) mit einem Inversionseingang (e⁻) verbunden mit der Gleichstromquelle und mit einem Direkteingang (e⁺) verbunden mit einem Potentiometer (22) umfaßt.

5. Anlage gemäß Anspruch 2, dadurch gekennzeichnet, daß ein digitaler Spannungsmesser (34) angeschlossen ist.

6. Anlage gemäß Anspruch 5, dadurch gekennzeichnet, daß des weiteren ein Mittel (30) zur Messung der Dicke des niedergeschlagenen Belags dazugehört, das in der Beschichtungskammer (10) angeordnet ist und mit der Steuerung (32) des Verdampfungsmittels verbunden ist.

7. Anlage gemäß Anspruch 6, dadurch gekennzeichnet, daß sie einen Rechner (36) mit zwei Eingängen umfaßt, wovon der eine (E1) mit dem Spannungsmesser (34), von dem er den Spannungswert (V) erhält, und der andere (E2) mit der Steuerung (32) des Verdampfungsmittels, von dem er ein Meßsignal (e) für die Dicke des niedergeschlagenen Belags erhält, verbunden ist; dieser Rechner (36) berechnet die Ableitung (dV/de) der Spannung (V) im Verhältnis zur Dicke (e) und verfügt über einen Ausgang (S) verbunden mit der Steuerung (32) des Verdampfungsmittels und liefert über diesen Ausgang ein Haltesignal, wenn die genannte Ableitung null ist.

**Claims**

1. Method for controlling the thickness of an antireflection coating when deposited on one of the faces of a semiconductor laser (14), in which the laser is fed with a constant current (16) during depositing, this method being characterized in that the voltage (V) is measured at the laser terminals, the passage of this voltage through a maximum being detected, which indicates that the antireflection coating has a thickness providing it with minimum reflectivity.

2. Installation for depositing an antireflection coating on one of the faces of a semiconductor laser for performing the method according to claim 1, said installation including a depositing chamber (10) equipped with an evaporation device (12) and a laser support (s), a means for controlling the evaporation device (12) and a constant current source (16) connected to a connection (18) opening inside the chamber, said installation being characterized in that it incorporates a device suitably adapted to detect the moment when the voltage at the terminals of the current source passes through a maximum.

3. Installation according to claim 2, characterized in that it further includes a device (36) able to deliver a stoppage signal to the device (32) for controlling the evaporation device (12) when the voltage passes through a maximum.

4. Installation according to claim 2, characterized in that it includes a differential amplifier (20) having one inverting input (e⁻) connected to the constant current source and one direct input (e⁺) connected to a potentiometer (22).

5. Installation according to claim 2, characterized in that it includes a digital voltmeter (34).

6. Installation according to claim 5, characterized in that it further includes a device (30) for measuring the thickness of the deposited coating, this device being disposed inside the chamber (10) and being connected to the device (32) for controlling the evaporation device.

7. Installation according to claim 6, characterized in that it includes a computer (36) having two inputs, one (E1) being connected to the voltmeter (34) from which it receives the value of the voltage (V), the other (E2) being connected to the device (32) for controlling the evaporation device from which it receives a signal ($e$) for measuring the thickness of the deposited coating, this computer (36) calculating the differential coefficient (dV/de) of the voltage (V) with respect to the thickness (e) and having one output (S) connected to the device (32) for controlling the evaporation device, the computer delivering a stoppage signal to said output when said differential coefficient is zero.

# FIG. 1

# FIG. 2

FIG. 3

FIG. 4

# FIG. 5